# EUROPÄISCHE PATENTSCHRIFT

(11) **EP 2 775 612 B1**
(45) Veröffentlichungstag und Bekanntmachung des Hinweises auf die Patenterteilung: **18.07.2018**
(21) Anmeldenummer: 14000744.4
(22) Anmeldetag: 03.03.2014
(51) Int. Cl.: H03F 3/58, H03F 3/189, H01J 25/34

(54) **Verfahren zum Betreiben eines Wanderfeldröhrenmoduls**
Method for operating a travelling-wave tube module
Procédé de fonctionnement d'un module de tubes à ondes progressives

(30) Priorität: 08.03.2013 DE 102013003904
(43) Veröffentlichungstag der Anmeldung: 10.09.2014
(73) Patentinhaber: Tesat-Spacecom GmbH & Co. KG, 71522 Backnang (DE)
(72) Erfinder: Reinwald, Gerhard, 71546 Aspach (DE); Katz, Hanspeter, 70374 Stuttgart (DE)
(74) Vertreter: LKGLOBAL Lorenz & Kopf PartG mbB Patentanwälte

(56) Entgegenhaltungen:
- EP-A1- 2 445 103
- EP-A2- 2 099 054
- WO-A1-86/07217
- WO-A1-2006/065388
- US-A- 5 500 621

## Beschreibung

### GEBIET DER ERFINDUNG

Die Erfindung betrifft ein Verfahren zum Betreiben eines Wanderfeldröhrenmoduls eines Kommunikationssatelliten.

### HINTERGRUND DER ERFINDUNG

Als Leistungsverstärker werden in Satelliten vornehmlich Wanderfeldröhrenverstärker (TWTA, Travelling Wave Tube Amplifier) eingesetzt, die in der Regel als Wanderfeldröhrenmodule ausgeführt sind. Diese umfassen eine Wanderfeldröhre, die vornehmlich die Hochfrequenz-Eigenschaften bestimmt, und eine Stromversorgung, die die Versorgungsspannungen für die Wanderfeldröhre erzeugt und können zusätzlich eine Telemetrie- und/oder Telekommando-Schnittstelle zum Satelliten und eine Steuerung umfassen. Ergänzt werden kann das Wanderfeldröhrenmodul durch einen Vorverstärker (auch Kanalverstärker genannt), der auch einen Linearisierer beinhalten kann. In dieser Kombination spricht man dann von einem Hochfrequenz-Leistungsmodul.

In einer Wanderfeldröhre wird ein Hochfrequenzsignal dadurch verstärkt, dass ein Elektronenstrahl an einem in der Regel wendelförmigen Leiter vorbeigeführt wird, durch den das Hochfrequenzsignal fließt. Bei geeigneter Auslegung des Leiters und des Elektronenstrahls kann dabei Energie von dem Elektronenstrahl auf das Hochfrequenzsignal übertragen werden.

Die EP 2 445 103 A1 beschreibt ein Energiemanagementsystem für einen Doppelwanderfeldröhrenverstärker.

Die US 5 500 621 A beschreibt Energieversorgungseinrichtungen für den Betrieb von Wanderwellenrähren und insbesondere für solche Röhren, welche in Raumfahrzeugen eingesetzt werden.

Die dort beschriebene Energieversorgungseinrichtung umfasst eine mit der Kathode gekoppelte Kathodenstrom-Messeinrichtung zum Erzeugen eines den Kathodenstrom der Wanderwellenröhre darstellenden Kathodenstromsignals und eine mit dem Wendelleiter verbundene Wendelleiterstrom-Messeinrichtung zum Erzeugen eines den Wendelleiterstrom der Wanderwellenröhre darstellenden Wendelleiterstromsignals.

Im Allgemeinen wird eine Wanderfeldröhre auf einen Betrieb bei oder nahe Sättigung ausgelegt. Um einen möglichst hohen Wirkungsgrad zu erzielen, werden, unter anderem, mehrstufige Kollektoren mit einer Mehrzahl von Kollektorelementen bzw. Kollektorstufen eingesetzt, die die Restenergie des verbrauchten Elektronenstrahls größtenteils zurückgewinnen. Dabei ist das Ziel, die Spannungen der Kollektorstufen so zu wählen, dass die Wanderfeldröhre bei Sättigung den höchst möglichen Wirkungsgrad erzielt. Bei anliegendem Hochfrequenz-Eingangssignal verteilt sich der Kathodenstrom mehr oder weniger gleichmäßig auf die verschiedenen Kollektorstufen und führt so zu einer Verteilung der Verlustleistung auf alle Kollektorstufen.

Im Ruhebetrieb, wenn die Wanderfeldröhre ohne Ansteuerung betrieben wird, gibt der Elektronenstrahl keine Energie ab und trifft somit komplett auf die letzte Kollektorstufe. Dadurch konzentriert sich die gesamte Verlustleistung auf die letzte Stufe des Kollektors. Um die Verlustleistung in diesem Fall auf einen akzeptablen Wert zu begrenzen, ist die Spannung an dieser Stufe nicht frei wählbar und muss unter Umständen auf einen niedrigeren Wert eingestellt werden, als es für einen optimalen Wirkungsgrad nötig wäre. Dabei kommt es vor, dass diese Stufe nahe an ihrer thermischen Belastbarkeit betrieben wird.

Es wird darüber nachgedacht, eine zusätzliche Kollektorstufe einzuführen, die es erlaubt, die letzte Stufe bei einer niedrigeren Spannung, und somit einer niedrigeren Verlustleistung bei Nichtansteuerung, zu betreiben, ohne dabei an Wirkungsgrad zu verlieren. Diese zusätzliche Stufe macht allerdings sowohl Stromversorgung als auch Wanderfeldröhre komplexer und somit schwerer und teurer.

### ZUSAMMENFASSUNG DER ERFINDUNG

Es ist Aufgabe der Erfindung, ein leichtes und kostengünstiges Wanderfeldröhrenmodul für einen Kommunikationssatelliten bereitzustellen.

Diese Aufgabe wird durch den Gegenstand der unabhängigen Ansprüche gelöst. Weitere Ausführungsformen der Erfindung ergeben sich aus den abhängigen Ansprüchen und aus der folgenden Beschreibung.

Ein Aspekt der Erfindung betrifft ein Verfahren zum Betreiben eines Wanderfeldröhrenmoduls eines Kommunikationssatelliten. Das Wanderfeldröhrenmodul kann eine Wanderfeldröhre und eine Steuerung zum Ansteuern der Wanderfeldröhre umfassen. Es ist zu verstehen, dass der Kommunikationssatellit eine Mehrzahl von Wanderfeldröhrenmodulen aufweisen kann, die jeweils einem Kanal des Satelliten zugeordnet sein können.

Gemäß einer Ausführungsform der Erfindung umfasst das Verfahren die Schritte von: Empfangen eines Hochfrequenzsignals von einer Antenne des Kommunikationssatelliten; Feststellen, dass das Hochfrequenzsignal verstärkt werden soll; Erhöhen des Kathodenstroms einer Wanderfeldröhre auf einen vorbestimmten Betriebswert, wenn das Hochfrequenzsignal verstärkt werden soll; Verstärken des Hochfrequenzsignals mit der Wanderfeldröhre; Erfassen und Auswerten einer Messgröße des Wanderfeldröhrenmoduls, wobei basierend auf der Messgröße festgestellt wird, dass das Hochfrequenzsignal verstärkt werden soll, und wobei die Messgröße über einen Zeitraum erfasst wird, und ausgewertet wird, ob innerhalb des Zeitraums wenigstens ein Spitzenwert der Messgröße über einem Schwellenwert liegt, um festzustellen, dass das Hochfrequenzsignal verstärkt werden soll. Mit anderen Worten kann die Wanderfeldröhre zwischen zwei Betriebsarten (Ruhebetrieb und Verstärkerbetrieb) umgestellt werden, indem der Kathodenstrom an die Betriebsart angepasst wird.

Gemäß einer Ausführungsform der Erfindung umfasst das Verfahren alternativ oder zusätzlich die Schritte von: Feststellen, dass kein Hochfrequenzsignal verstärkt werden soll; Reduzieren des Kathodenstroms auf einen vorbestimmten Ruhewert. Genauso, wie beim Wechsel vom Ruhebetrieb in den Verstärkerbetrieb der Kathodenstrom erhöht wird, kann beim Wechsel vom Verstärkerbetrieb in den Ruhebetrieb der Kathodenstrom abgesenkt werden.

Auf diese Weise kann die Wanderfeldröhre in beiden Betriebsarten auf einen optimalen Wirkungsgrad eingestellt werden. D.h., die Höhe des Kathodenstroms im Ruhebetrieb und im Verstärkerbetrieb ist derart gewählt, dass die Wanderfeldröhre immer einen optimalen Wirkungsgrad aufweist.

Beispielsweise wird im Ruhebetrieb zur Einstellung der Ausgangsleistung der Kathodenstrom so weit reduziert, dass die Verlustleistung einen akzeptablen Wert nicht überschreitet und das letzte Kollektorelement im Kollektor somit in einem thermisch sicheren Bereich betrieben werden kann. In der Regel kann hiermit die Verlustleistung des letzten Kollektorelements auf 50 % reduziert werden.

Auch wenn das Reduzieren des Ruhestroms nicht sofort erfolgt, wenn kein Hochfrequenzsignal mehr anliegt, ist durch die thermische Zeitkonstante des Kollektors genügend Zeit vorhanden, um die Betriebsart zu wechseln.

Ein Wechsel der Betriebsart kann auch nur dann erfolgen (bzw. nötig sein), wenn der Betrieb ohne Ansteuerung, d.h. ohne zu verstärkendes Hochfrequenzsignal, entsprechend lange dauert.

Gemäß einer Ausführungsform der Erfindung wird der Kathodenstrom auf einen Wert größer Null reduziert. Mit anderen Worten kann der Ruhewert größer als Null sein, beispielsweise, um ein anschließendes Erhöhen auf den Betriebswert zu beschleunigen.

Um die Ausgangsleistung des Wanderfeldröhrenmoduls anpassen zu können, erlauben bestimmte Geräte, diese über eine Telekommandoschnittstelle zu reduzieren. Dabei kann über ein entsprechendes Telekommando der Kathodenstrom so weit abgesenkt werden, bis der gewünschte Ausgangspegel erreicht wird. Diese in einem Wanderfeldröhrenmodul bereits vorhandene Funktion kann auch dazu verwendet werden, den Kathodenstrom von einem Ruhewert auf einen Betriebswert umzustellen und umgekehrt.

Gemäß einer Ausführungsform der Erfindung umfasst das Verfahren weiter den Schritt von: Empfangen eines Telekommandos über eine Antenne des Satelliten, dass das Hochfrequenzsignal verstärkt werden soll. Beispielsweise wird das Telekommando in einer Bodenstation erzeugt und von der Bodenstation an den Satelliten versendet. In der Bodenstation kann ermittelt werden, wann der Satellit ein Hochfrequenzsignal verstärken soll, beispielsweise, wenn ein Nutzer des Satelliten Sendezeit gebucht hat, oder wenn ein Auftrag zum Versenden eines Hochfrequenzsignals ansteht.

Gemäß der Erfindung umfasst das Verfahren weiter den Schritt von: Erfassen und Auswerten einer Messgröße bzw. eines Parameters des Wanderfeldröhrenmoduls, wobei basierend auf der Messgröße festgestellt wird, dass das Hochfrequenzsignals verstärkt werden soll. Es ist auch möglich, dass das Wanderfeldröhrenmodul selbstständig feststellt, wann die Betriebsart gewechselt werden soll.

Gemäß einer Ausführungsform der Erfindung ist die Messgröße eine Eingangsleistung eines Eingangsstroms des Wanderfeldröhrenmoduls. Um zu ermitteln, ob gerade ein Hochfrequenzsignal verstärkt wird oder nicht, kann die Steuerung den Eingangsstrom des Wanderfeldröhrenmoduls überwachen und daraus die momentan aufgenommene Leistung des Wanderfeldröhrenmoduls bestimmen. Aus zeitlichen Spitzen der Leistung kann bestimmt werden, ob gerade ein Hochfrequenzsignal verstärkt wird.

Insbesondere kann die DC-Spitzeneingangsleistung des Wanderfeldröhrenmoduls bestimmt werden. Fällt die Leistung unter einen gewissen Wert, der Nichtansteuerung bzw. dem Ruhebetrieb entspricht, wird der Kathodenstrom automatisch abgesenkt. Steigt die Spitzeneingangsleistung wieder über einen gewissen Wert, wird der Kathodenstrom wieder auf den Wert vor der Absenkung eingestellt und damit in den Verstärkerbetrieb gewechselt. Durch eine geeignete Zeitkonstante kann die Absenkung des Kathodenstroms erst dann erfolgen, wenn der ermittelte Ruhebetrieb eine gewisse (beispielsweise vorbestimmte) Zeitdauer überschreitet.

Gemäß einer Ausführungsform der Erfindung ist die Messgröße eine Leistung des Hochfrequenzsignals. Alternativ oder zusätzlich kann die Steuerung des Wanderfeldröhrenmoduls das (unverstärkte) Hochfrequenzsignal direkt überwachen. Beispielsweise kann über einen Vorverstärker des Wanderfeldröhrenmoduls die HF-Spitzeneingangsleistung gemessen und die Veränderung des Kathodenstroms entsprechend über diesen Wert gesteuert werden.

Gemäß der Erfindung wird die Messgröße über einen Zeitraum erfasst und es wird ausgewertet, ob innerhalb des Zeitraums wenigstens ein Spitzenwert der Messgröße über einem Schwellenwert liegt, um festzustellen, dass das Hochfrequenzsignal verstärkt werden soll. Wie bereits gesagt, kann die Messgröße eine Eingangsleistung der Stromversorgung des Wanderfeldröhrenmoduls und/oder eine Eingangsleistung des Hochfrequenzsignals sein. Immer wenn Spitzenwerte der Eingangsleistung über einen bestimmten Schwellenwert steigen, kann angenommen werden, dass ein Verstärkerbetrieb durchgeführt wird.

Umgekehrt kann die Messgröße über einen Zeitraum erfasst werden und ausgewertet werden, ob innerhalb des Zeitraums kein Spitzenwert der Messgröße unter dem Schwellenwert liegt, um festzustellen, dass das Hochfrequenzsignal nicht (mehr) verstärkt werden soll. Wenn beispielsweise für einen vorbestimmten Zeitraum kein Spitzenwert mehr in der Eingangsleistung erfasst wird, der oberhalb des Schwellenwerts liegt, kann angenommen werden, dass ein Ruhebetrieb durchgeführt wird.

Gemäß einer Ausführungsform der Erfindung wird der Kathodenstrom durch Vermindern einer Anodenspannung reduziert. Beispielsweise kann einem Kathodenstromregler des Wanderfeldröhrenmoduls ein entsprechender Sollwert (d.h. der Ruhewert oder Betriebswert) vorgegeben werden und der Kathodenstromregler über die Anodenspannung den Kathodenstrom entsprechend einstellen. Der Einstellbereich umfasst im Allgemeinen 4 dB der Ausgangsleistung, was ca. 50 % des Kathodenstroms entspricht.

Ein weiterer Aspekt der Erfindung betrifft ein Wanderfeldröhrenmodul für einen Kommunikationssatelliten. Es ist zu verstehen, dass Merkmale des Wanderfeldröhrenmoduls auch Merkmale des Verfahrens sein können und umgekehrt.

Gemäß der Erfindung umfasst das Wanderfeldröhrenmodul eine Wanderfeldröhre und eine Steuerung zum Ansteuern der Wanderfeldröhre. Gemäß der Erfindung ist das Wanderfeldröhrenmodul ausgeführt, ein Hochfrequenzsignal über eine Antenne des Kommunikationssatelliten zu erhalten.

Die Wanderfeldröhre umfasst einen Emitter, der dazu ausgeführt ist, bei Anlegen einer Spannung einen Elektronenstrahl zu erzeugen; einen Verstärkerabschnitt, der von dem Elektronenstrahl durchlaufen wird und in dem ein Leiter angeordnet ist, in dem ein den Leiter durchlaufendes Hochfrequenzsignal durch den Elektronenstrahl verstärkbar ist, und einen Kollektor, der dazu ausgeführt ist, den Elektronenstrahl aufzunehmen, wodurch ein Kathodenstrom entsteht. Der Kollektor umfasst eine Mehrzahl von Kollektorelementen, die dazu ausgeführt sind, im Verstärkerbetrieb der Wanderfeldröhre jeweils einen Teil des Elektronenstrahls aufzunehmen. In einem Ruhebetrieb, in dem kein Hochfrequenzsignal verstärkt wird, trifft der Elektronenstrahl lediglich auf ein letztes Kollektorelement, das in diesem Fall den gesamten Kathodenstrom aufnimmt. Durch Absenken des Kathodenstroms im Ruhebetrieb kann das letzte Kollektorelement entlastet werden.

Die Steuerung des Wanderfeldröhrenmoduls ist dazu ausgeführt, den Kathodenstrom einzustellen. Weiter kann die Steuerung feststellen, dass das Hochfrequenzsignal verstärkt werden soll, um in Reaktion darauf den Kathodenstrom auf einen vorbestimmten Betriebswert zu erhöhen. Beispielsweise kann die Steuerung die Anodenspannung so weit erhöhen, dass ein bestimmter Betriebswert für den Kathodenstrom erreicht wird. Umgekehrt kann die Steuerung auch feststellen, dass der Verstärkerbetrieb beendet werden soll, und dann den Kathodenstrom auf einen Ruhewert absenken, beispielsweise durch Vermindern der Anodenspannung auf einen bestimmten Ruhewert.

Gemäß der Erfindung ist die Steuerung dazu ausgeführt, festzustellen, dass das Hochfrequenzsignal verstärkt werden soll und in Reaktion darauf den Kathodenstrom auf einen vorbestimmten Betriebswert zu erhöhen, und das Hochfrequenzsignal mit der Wanderfeldröhre zu einem verstärkten Hochfrequenzsignal zu verstärken, wobei die Steuerung ausgeführt ist zum Erfassen und Auswerten einer Messgröße des Wanderfeldröhrenmoduls, wobei die Steuerung ausgeführt ist, basierend auf der Messgröße festzustellen, ob das Hochfrequenzsignal verstärkt werden soll, wobei die Steuerung ausgeführt ist, die Messgröße über einen Zeitraum zu erfassen, und auszuwerten, ob innerhalb des Zeitraums wenigstens ein Spitzenwert der Messgröße über einem Schwellenwert liegt, um festzustellen, dass das Hochfrequenzsignal verstärkt werden soll.

Gemäß einer Ausführungsform der Erfindung ist die Steuerung dazu ausgeführt, ein Telekommando zu empfangen, das die Steuerung dazu anweist, das Hochfrequenzsignal zu verstärken. Beispielsweise kann ein Telekommandomodul der Steuerung ein entsprechendes Telekommando empfangen und auswerten.

Gemäß einer Ausführungsform der Erfindung ist die Steuerung dazu ausgeführt, eine Messgröße des Wanderfeldröhrenmoduls auszuwerten, um festzustellen, dass ein Hochfrequenzsignal verstärkt werden soll. Diese Messgröße kann beispielsweise ein Eingangsstrom des Wanderfeldröhrenmoduls aus einer Stromversorgung des Satelliten sein.

Im Folgenden werden Ausführungsbeispiele der Erfindung mit Bezug auf die beiliegenden Figuren detailliert beschrieben.

### KURZE BESCHREIBUNG DER FIGUREN

Fig. 1 zeigt eine schematische Ansicht eines Kommunikationssatelliten gemäß einer Ausführungsform der Erfindung.
Fig. 2 zeigt eine schematische Ansicht eines Wanderfeldröhrenmoduls gemäß einer Ausführungsform der Erfindung.
Fig. 3 zeigt eine schematische Ansicht eines Wanderfeldröhrenmoduls gemäß einer weiteren Ausführungsform der Erfindung.
Fig. 4 zeigt ein Flussdiagramm für ein Verfahren zum Betreiben eines Wanderfeldröhrenmoduls gemäß einer Ausführungsform der Erfindung.

Grundsätzlich sind identische oder ähnliche Teile mit den gleichen Bezugszeichen versehen.

### DETAILLIERTE BESCHREIBUNG VON AUSFÜHRUNGSBEISPIELEN

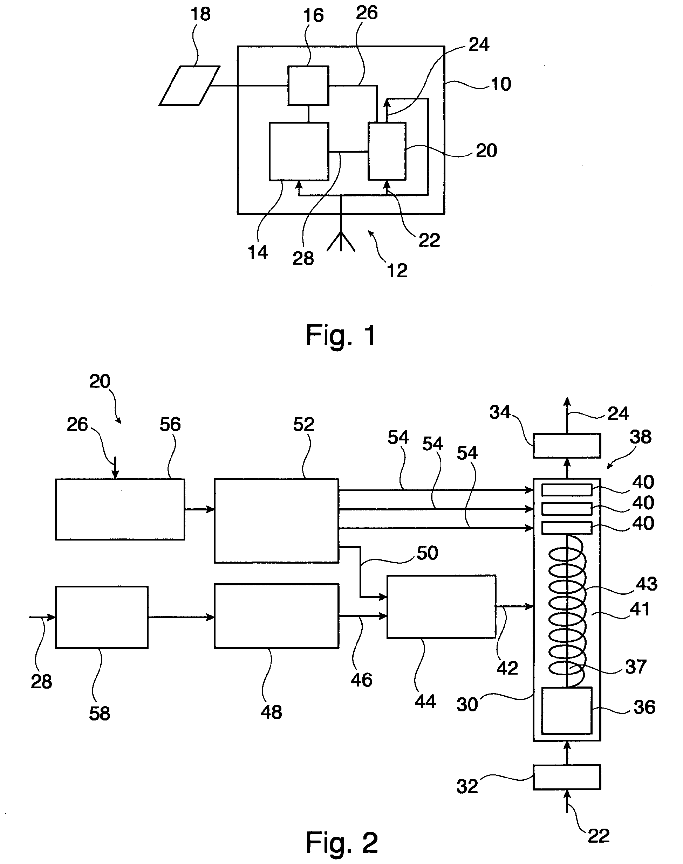

Fig. 1 zeigt einen Kommunikationssatelliten 10 mit einer Antenne 12, einer Steuereinheit 14 und einer Stromversorgung 16, die beispielsweise von einem Sonnenpanel 18 mit Energie versorgt wird.

Weiter weist der Kommunikationssatellit 10 ein Wanderfeldröhrenmodul 20 auf. In der Fig. 1 ist lediglich ein Kanal des Kommunikationssatelliten 10 dargestellt, in der Regel kann ein Kommunikationssatellit 10 mehrere Kanäle aufweisen, die jeweils ein Wanderfeldröhrenmodul 20 umfassen können.

Über die Antenne 12 kann der Kommunikationssatellit 10 ein Hochfrequenzsignal 22 empfangen und an das Wanderfeldröhrenmodul 20 weiterleiten. Dort wird das Hochfrequenzsignal 22 zu einem verstärkten Hochfrequenzsignal 24 verstärkt und kann wieder über die Antenne 12 (oder eine weitere Antenne) abgestrahlt werden. Über die Stromversorgung 16 wird das Wanderfeldröhrenmodul 20 dabei mit Strom 26 versorgt. Weiter kann das Wanderfeldröhrenmodul 20 von der Steuereinheit 14 angesteuert werden und beispielsweise Telekommandos 28 empfangen, die beispielsweise über die Antenne 12 empfangen und von der Steuereinheit 14 ausgewertet wurden.

Die Fig. 2 zeigt ein Wanderfeldröhrenmodul 20 detaillierter. Das Wanderfeldröhrenmodul 20 umfasst eine Wanderfeldröhre 30, die über einen Hochfrequenzeingang 32 das Hochfrequenzsignal 22 empfängt und das verstärkte Hochfrequenzsignal 24 über einen Hochfrequenzausgang 34 ausgibt.

Die Wanderfeldröhre 30 umfasst einen Emitter 36, mit dem ein Elektronenstrahl 37 erzeugt werden kann und einen Kollektor 38, der den Elektronenstrahl 37 wieder aufnimmt und eine Mehrzahl von Kollektorelementen 40 aufweist, auf die der Elektronenstrahl 37 im Verstärkerbetrieb der Wanderfeldröhre 30 aufgeteilt wird. Auf diese Weise kann der Strom aus dem Elektronenstrahl wieder zum Emitter 36 zurückgeführt werden. Zwischen dem Emitter und dem Kollektor 38 liegt ein Verstärkerbereich 41, in dem das Hochfrequenzsignal 22 durch den Elektronenstrahl verstärkt wird. Das Hochfrequenzsignal 22 wird dabei durch einen Leiter 43 durch die Wanderfeldröhre 30 geschickt.

Der Emitter 36 umfasst eine Kathode zum Abgeben der Elektronen und eine Anode, die auf eine Anodenspannung 42 gesetzt werden kann, um den Elektronenstrahl 37 zu erzeugen. Die Stärke des Elektronenstrahls 37 wird über die Anodenspannung 42 eingestellt, die von einem Kathodenstromregler 44 erzeugt wird. Den entsprechenden Wert 46 für den Kathodenstrom erhält der Kathodenstromregler 44 von einer Steuerung 48. Eine benötigte Spannung 50 wird von einer Hochspannungserzeugung 52 bereitgestellt.

Die Hochspannungserzeugung 52, die auch die Spannungen 54 erzeugt, die an den Kollektorelementen 40 anliegen, wird von einem Vorregler und Filter 56 mit Strom versorgt, der den Strom 26 aus der Stromversorgung 16 des Satelliten 10 zu einem konstanten und gleichmäßigen Gleichstrom umwandelt.

Weiter kann das Wanderfeldröhrenmodul 20 eine Telekommando-Schnittstelle 58 umfassen, die Telekommandos 28 für die Steuerung 48 vorverarbeitet.

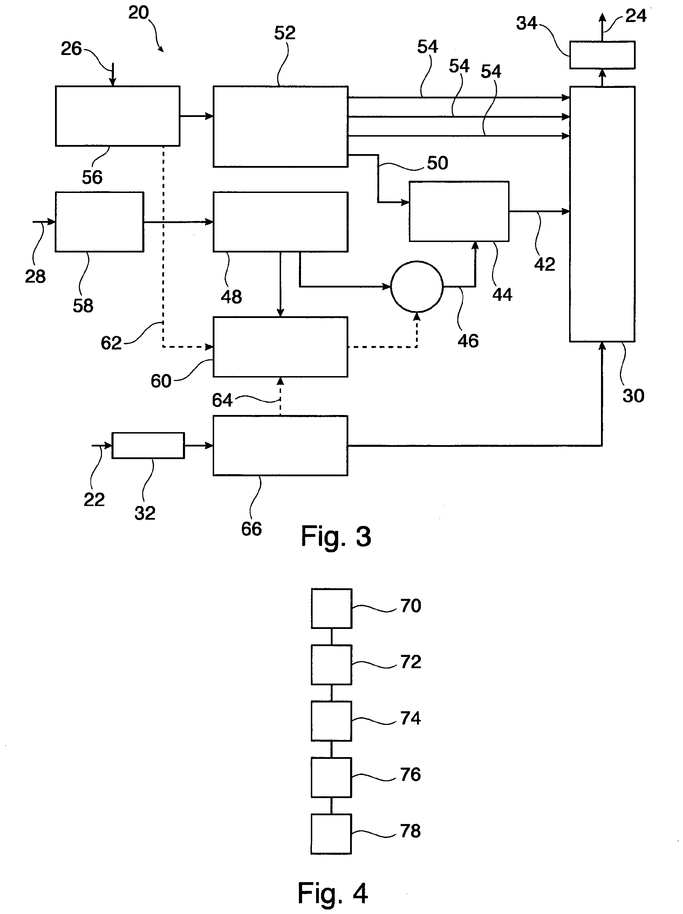

Die Fig. 3 zeigt ein Wanderfeldröhrenmodul 20, das gegenüber der Fig. 2 um einige Komponenten erweitert wurde. Die Steuerung 48 umfasst eine Kontrolllogik 60, die die von dem Vorregler und Filter 56 aufgenommene Eingangsleistung 62 überwachen und auswerten kann. Alternativ oder zusätzlich kann die Kontrolllogik 60 die Eingangsleistung 64 das Hochfrequenzsignal 22 überwachen und auswerten. Beispielsweise erhält die Kontrolllogik 60 diese Werte 64 aus einem Kanalverstärker und/oder Linearisierer 66, mit dem das unverstärkte Hochfrequenzsignal 22 vorverstärkt und/oder linearisiert werden kann, bevor es der Wanderfeldröhre 20 zugeführt wird.

Aus den erfassten Werten 62 und/oder 64 ermittelt die Kontrolllogik, in welcher Betriebsart (Verstärkerbetrieb oder Ruhebetrieb) die Wanderfeldröhre 30 betrieben werden soll und passt den Vorgabewert 46 für den Kathodenstrom entsprechend an.

Die Fig. 4 zeigt ein Flussdiagramm, mit dem das Wanderfeldröhrenmodul 20 betrieben werden kann.

Im Schritt 70 wird festgestellt, dass die Wanderfeldröhre 30 angesteuert wird oder angesteuert werden soll, mit anderen Worten, dass die Wanderfeldröhre 30 im Verstärkerbetrieb betrieben werden soll.

Dies kann beispielsweise über ein entsprechendes Telekommando 28 erfolgen, das von der Telekommandoschnittstelle 58 empfangen und dann von der Steuerung 48 entsprechend ausgewertet wird. Das Telekommando 28 kann beispielsweise von einer Bodenstation an den Satelliten 10 gesendet werden.

Alternativ oder zusätzlich kann auch das Wanderfeldröhrenmodul 20 selbstständig feststellen, dass die Wanderfeldröhre 30 angesteuert wird. Dies kann beispielsweise durch Erfassen der Werte 62 und/oder 64 erfolgen. Immer dann, wenn Spitzenwerte dieser Eingangsleistungen einen bestimmten vorgegebenen Schwellenwert überschreiten, nimmt die Kontrolllogik 60 an, dass die Wanderfeldröhre 30 angesteuert wird.

Im Schritt 72 wird der Kathodenstrom auf einen vorbestimmten Betriebswert 46 erhöht. Dazu wird dem Kathodenstromregler 44, beispielsweise von der Kontrolllogik 60 oder von der Steuerung 48, der zu erreichende Betriebswert 36 mitgeteilt und dieser regelt die Anodenspannung 42 entsprechend.

Im Schritt 74 wird das empfangene Hochfrequenzsignal 22 von der Wanderfeldröhre 30 verstärkt und anschließend wieder vom Satelliten 10 versendet. Die Wanderfeldröhre 30 kann dabei einen hohen Wirkungsgrad erzielen, da die Kollektorelemente 40 und die Kollektorspannungen 54 so gewählt sind, dass im Verstärkerbetrieb ein möglichst hoher Wirkungsgrad erzielt wird.

Im Schritt 76 wird festgestellt, dass die Wanderfeldröhre nicht angesteuert wird bzw. nicht mehr angesteuert werden soll. Dies kann analog dem Schritt 70 über ein Telekommando oder über das Erfassen von Werten innerhalb des Satelliten 10 erfolgen.

Im Schritt 78 wird anlog dem Schritt 72 der Kathodenstrom wieder auf einen Ruhewert 46 reduziert. Obwohl im Ruhebetrieb der Elektronenstrahl jetzt nur noch auf das letzte Kollektorelement 40 trifft, wird dieses nicht beschädigt oder zumindest stark erhitzt, da der Kathodenstrom reduziert wurde. Auch im Ruhebetrieb wird auf diese Weise der Wirkungsgrad erhöht. Zusätzliche Kollektorelemente sind nicht notwendig.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Betreiben eines Wanderfeldröhrenmoduls (20) eines Kommunikationssatelliten (10), das Verfahren umfassend die Schritte:
Empfangen eines Hochfrequenzsignals (22) von einer Antenne (12) des Kommunikationssatelliten (10);
Feststellen, dass das Hochfrequenzsignal (22) verstärkt werden soll;
Erhöhen des Kathodenstroms einer Wanderfeldröhre (30) auf einen vorbestimmten Betriebswert, wenn das Hochfrequenzsignal (22) verstärkt werden soll;
Verstärken des Hochfrequenzsignals (22) mit der Wanderfeldröhre (30);
Erfassen und Auswerten einer Messgröße (62, 64) des Wanderfeldröhrenmoduls (20);
wobei basierend auf der Messgröße (62, 64) festgestellt wird, dass das Hochfrequenzsignal (22) verstärkt werden soll;
wobei die Messgröße (62, 64) über einen Zeitraum erfasst wird, und ausgewertet wird, ob innerhalb des Zeitraums wenigstens ein Spitzenwert der Messgröße (62, 64) über einem Schwellenwert liegt, um festzustellen, dass das Hochfrequenzsignal verstärkt werden soll.

2. Verfahren nach Anspruch 1, weiter umfassend die Schritte:
Feststellen, dass kein Hochfrequenzsignal (22) verstärkt werden soll;
Reduzieren des Kathodenstroms auf einen vorbestimmten Ruhewert.

3. Verfahren nach Anspruch 1,
wobei der Kathodenstrom auf einen Wert größer Null reduziert wird.

4. Verfahren nach einem der vorhergehenden Ansprüche, weiter umfassend den Schritt:
Empfangen eines Telekommandos (28) über eine Antenne (12) des Kommunikationssatelliten (10), dass das Hochfrequenzsignal (22) verstärkt werden soll.

5. Verfahren nach Anspruch 4,
wobei das Telekommando (28) in einer Bodenstation erzeugt und von der Bodenstation an den Kommunikationssatelliten (10) versendet wird.

6. Verfahren nach einem der vorhergehenden Ansprüche,
wobei die Messgröße eine Eingangsleistung (62) eines Eingangsstroms des Wanderfeldröhrenmoduls (20) ist.

7. Verfahren nach einem der vorhergehenden Ansprüche,
wobei die Messgröße eine Leistung (64) des Hochfrequenzsignals ist.

8. Verfahren nach einem der vorhergehenden Ansprüche;
wobei der Kathodenstrom durch Vermindern einer Anodenspannung reduziert wird.

9. Wanderfeldröhrenmodul (20) für einen Kommunikationssatelliten (10), umfassend:
eine Wanderfeldröhre (30); und
eine Steuerung (48) zum Ansteuern der Wanderfeldröhre;
wobei das Wanderfeldröhrenmodul (20) ausgeführt ist, ein Hochfrequenzsignal (22) über eine Antenne (12) des Kommunikationssatelliten (10) zu erhalten;
wobei die Wanderfeldröhre (30) umfasst:
einen Emitter (36), der dazu ausgeführt ist, bei Anlegen einer Spannung einen Elektronenstrahl (37) zu erzeugen;
einen Verstärkerabschnitt (41), der von dem Elektronenstrahl (37) durchlaufen wird und in dem ein Leiter (43) angeordnet ist, in dem ein den Leiter (43) durchlaufendes Hochfrequenzsignal (22) durch den Elektronenstrahl (37) verstärkbar ist,
einen Kollektor (38), der dazu ausgeführt ist, den Elektronenstrahl (37) aufzunehmen, wodurch ein Kathodenstrom entsteht, wobei der Kollektor (38) eine Mehrzahl von Kollektorelementen (40) umfasst, die dazu ausgeführt sind, im Verstärkerbetrieb der Wanderfeldröhre (30) jeweils einen Teil des Elektronenstrahls (37) aufzunehmen;
wobei die Steuerung (48) dazu ausgeführt ist, den Kathodenstrom einzustellen;
wobei die Steuerung (48) dazu ausgeführt ist, festzustellen, dass das Hochfrequenzsignal (22) verstärkt werden soll und in Reaktion darauf den Kathodenstrom auf einen vorbestimmten Betriebswert zu erhöhen, und das Hochfrequenzsignal (22) mit der Wanderfeldröhre (30) zu einem verstärkten Hochfrequenzsignal (24) zu verstärken;
wobei die Steuerung (48) ausgeführt ist zum Erfassen und Auswerten einer Messgröße (62, 64) des Wanderfeldröhrenmoduls (20);
wobei die Steuerung (48) ausgeführt ist, basierend auf der Messgröße (62, 64) festzustellen, ob das Hochfrequenzsignal (22) verstärkt werden soll;
wobei die Steuerung (48) ausgeführt ist, die Messgröße (62, 64) über einen Zeitraum zu erfassen, und auszuwerten, ob innerhalb des Zeitraums wenigstens ein Spitzenwert der Messgröße (62, 64) über einem Schwellenwert liegt, um festzustellen, dass das Hochfrequenzsignal verstärkt werden soll.

10. Wanderfeldröhrenmodul (20) nach Anspruch 9,
wobei die Steuerung (48) dazu ausgeführt ist, ein Telekommando (28) zu empfangen, das die Steuerung (48) dazu anweist, das Hochfrequenzsignal (22) zu verstärken.

## Claims

1. A method for operating a traveling-wave tube module (20) of a communication satellite (10), the method comprising the steps of:
receiving a high-frequency signal (22) from an antenna (12) of the communication satellite (10);
determining that the high-frequency signal (22) is to be amplified;
increasing a cathode current of a traveling-wave tube (30) to a predetermined operating value if the high-frequency signal (22) is to be amplified;
amplifying the high-frequency signal (22) using the traveling-wave tube (30);
detecting and analyzing a measured value (62, 64) of the traveling-wave tube module (20);
wherein it is determined based on the measured value (62, 64) that the high-frequency signal (22) is to be amplified;
wherein the measured value (62, 64) is detected over a time period, and the analyzing involves determining whether at least one peak value of the measured value (62, 64) lies above a threshold value in order to determine that the high-frequency signal is to be amplified.

2. The method of claim 1, further comprising the steps of:
determining that no high-frequency signal (22) is to be amplified; and
reducing the cathode current to a predetermined idle value.

3. The method of claim 1,
wherein the cathode current is reduced to a value greater than zero.

4. The method of any one of the preceding claims, further comprising the step of:
receiving a telecommand (28) via an antenna (12) of the communication satellite (10) instructing that the high-frequency signal (22) is to be amplified.

5. The method of claim 4,
wherein the telecommand (28) is generated in a ground station and transmitted from the ground station to the communication satellite (10).

6. The method of any one of the preceding claims,
wherein the measured value is an input power (62) of an input current of the traveling-wave tube module (20).

7. The method of any one of the preceding claims,
wherein the measured value is a power (64) of the high-frequency signal.

8. The method of any one of the preceding claims,
wherein the cathode current is reduced through reduction of an anode voltage.

9. A traveling-wave tube module (20) for a communication satellite (10), comprising:
a traveling-wave tube (30); and
a controller (48) configured to control the traveling-wave tube,
wherein the traveling-wave tube module (20) is configured to receive a high-frequency signal (22) via an antenna (12) of the communication satellite (10);
wherein the traveling-wave tube (30) comprises:
an emitter (36) configured to generate an electron beam (37) upon application of a voltage;
an amplifier section (41) through which the electron beam (37) passes and in which is arranged a conductor (43) in which a high-frequency signal (22) passing through the conductor (43) is amplifiable by the electron beam (37);
a collector (38) configured to absorb the electron beam (37), thus creating a cathode current, wherein the collector (38) comprises a plurality of collector elements (40) configured to absorb a respective portion of the electron beam (37) when the traveling-wave tube (30) is in amplifying operation;
wherein the controller (48) is configured to set the cathode current;
wherein the controller (48) is configured to determine that the high-frequency signal (22) is to be amplified and to increase the cathode current to a predetermined operating value in response to the determination that the high-frequency signal is to be amplified, and to amplify the high-frequency signal (22) with the traveling-wave tube (30) to an amplified high-frequency signal (24);
wherein the controller (48) is configured to detect and analyze a measured value (62, 64) of the traveling-wave tube module (20);
wherein the controller (48) is configured to determine, based on the measured value (62, 64), whether the high-frequency signal (22) is to be amplified;
wherein the controller (48) is configured to detect the measured value (62, 64) over a time period, and to determine whether at least one peak value of the measured value (62, 64) lies above a threshold value in order to determine that the high-frequency signal is to be amplified.

10. The traveling-wave tube module (20) of claim 9,
wherein the controller (48) is configured to receive a telecommand (28) that instructs the controller (48) to amplify the high-frequency signal (22).

## Revendications

1. Procédé de fonctionnement d'un module de tube à ondes progressives (20) d'un satellite de communication (10), le procédé comprenant les étapes consistant à:
Recevoir un signal à haute fréquence (22) provenant d'une antenne (12) du satellite de communication (10);
Déterminer que le signal a haute fréquence (22) doit être amplifié;
Augmenter le courant de cathode d'un tube à ondes progressives (30) jusqu'à une valeur de fonctionnement prédéterminée lorsque le signal à haute fréquence (22) doit être amplifié;
Amplifier le signal à haute fréquence (22) avec le tube à ondes progressives (30);
Détection et évaluation d'une valeur de mesure (62, 64) du module de tube à ondes progressives;
dans lequel, sur la base de la valeur de mesure (62, 64), il est déterminé que le signal à haute fréquence (22) doit être amplifié;
dans lequel la valeur de mesure (62, 64) est détectée sur une période de temps et est évaluée si au moins une valeur de crête de la valeur de mesure (62, 64) est supérieure à une valeur seuil dans la période pour déterminer que le signal à haute fréquence doit être amplifié.

2. Procédé selon la revendication 1, comprenant en outre les étapes de:
Déterminer qu'aucun signal à haute fréquence (22) ne doit être amplifié;
Réduire le courant de cathode à une valeur de repos prédéterminée.

3. Procédé selon la revendication 1,
dans lequel le courant de cathode est réduit à une valeur supérieure à zéro.

4. Procédé selon l'une quelconque des revendications précédentes, comprenant en outre l'étape consistant à:
Réception d'une télécommande (28) via une antenne (12) du satellite de communication (10) que le signal à haute fréquence (22) doit être amplifier.

5. Procédé selon la revendication 4,
dans lequel la télécommande (28) est générée dans une station au sol et envoyée de la station au sol au satellite de communication (10).

6. Procédé selon l'une des revendications précédentes,
dans lequel la valeur de mesure est une puissance d'entrée (62) d'un courant d'entrée du module de tube à ondes progressives (20).

7. Procédé selon l'une des revendications précédentes,
dans lequel la valeur de mesure est une puissance (64) du signal à haute fréquence.

8. Procédé selon l'une des revendications précédentes;
dans lequel le courant de cathode est réduit en réduisant une tension d'anode.

9. Module de tube à ondes progressives (20) pour un satellite de communication (10), comprenant:
un tube à ondes progressives (30); et
un contrôleur (48) pour entraîner le tube à ondes progressives;
dans lequel le module de tube à ondes progressives (20) est adapté pour recevoir un signal à haute fréquence (22) via une antenne (12) du satellite de communication (10);
dans lequel le tube à ondes progressives (30) comprend:
un émetteur (36) qui est configuré pour générer un faisceau d'électrons (37) lors de l'application d'une tension;
une section d'amplificateur (41) à travers laquelle passe le faisceau d'électrons (37) et dans laquelle est disposé un conducteur (43) dans lequel un signal à haute fréquence (22) passant par le conducteur (43) peut être amplifié par le faisceau d'électrons (37),
un collecteur (38) adapté pour recevoir le faisceau d'électrons (37), produisant ainsi un courant cathodique, dans lequel le collecteur (38) comprenant une pluralité d'éléments collecteurs (40) qui sont conçus pour chacun recevoir une partie du faisceau d'électrons (37) dans un état d'amplification du tube à ondes progressives (30);
dans lequel le contrôleur (48) est adapté pour ajuster le courant de cathode;
dans lequel le contrôleur (48) est adapté pour déterminer que le signal à haute fréquence (22) doit être amplifié et en réaction de cela d'augmenter le courant de cathode à une valeur prédéterminée, et d'amplifier le signal à haute fréquence (22) avec le tube à ondes progressives (30) à un signal à haute fréquence amplifié (24);
dans lequel le contrôleur (48) est adapté pour détecter et évaluer une valeur de mesure (62, 64) du module de tube à ondes progressives (20);
dans lequel le contrôleur (48) est configuré pour déterminer, sur la base de la valeur de mesure (62, 64), si le signal à haute fréquence (22) doit être amplifié;
dans lequel le contrôleur (48) est adapté pour détecter la valeur de mesure (62, 64) sur une période de temps et pour évaluer si au moins une valeur de crête de la valeur de mesure (62, 64) est supérieure à une valeur seuil dans la période pour déterminer que le signal à haute fréquence doit être amplifié.

10. Module de tube à ondes progressives (20) selon la revendication 9,
dans lequel le contrôleur (48) est adapté pour recevoir une télécommande (28) ordonnant au contrôleur (48) d'amplifier le signal à haute fréquence (22).
